# FASCICULE DE BREVET EUROPEEN

(11) **EP 0 913 076 B1**
(45) Date de publication et mention de la délivrance du brevet: **05.12.2001**
(21) Numéro de dépôt: 96921860.1
(22) Date de dépôt: 18.07.1996
(51) Int. Cl.: H05K 3/04, H01F 41/04

(54) **PROCEDE DE FABRICATION DE CIRCUITS IMPRIMES ET CIRCUIT IMPRIME FABRIQUE SELON CE PROCEDE**
VERFAHREN ZUR HERSTELLUNG VON GEDRUCKTEN SCHALTUNGEN SOWIE NACH DIESEM VERFAHREN HERGESTELLTE GEDRUCKTE SCHALTUNG
METHOD FOR MAKING PRINTED CIRCUITS AND RESULTING PRINTED CIRCUIT

(43) Date de publication de la demande: 06.05.1999
(73) Titulaire: NagraID S.A., 2301 La Chaux-de-Fonds (CH)
(72) Inventeur: Droz, Francois, 2300 La Chaux-de-Fonds (CH)
(74) Mandataire: Wenger, Joel-Théophile
(86) Numéro de dépôt international: CH9600262
(87) Numéro de publication internationale: WO9804105

(56) Documents cités:
- DE-A- 1 690 542
- DE-A- 2 758 204
- DE-A- 3 330 738
- FR-A- 2 137 991
- FR-A- 2 674 724
- GB-A- 610 058
- GB-A- 1 138 628
- US-A- 2 622 054
- US-A- 4 138 924
- US-A- 4 356 627

## Description

### Domaine technique

La présente invention concerne un procédé de fabrication de circuits imprimés selon le préambule de la revendication 1. En outre, la présente invention concerne également un circuit imprimé, par exemple une bobine d'inductance dont les spires sont constituées par des pistes de circuit imprimé, fabriqué selon ce procédé.

### Technique antérieure

Dans la technique des cartes à puces et des transpondeurs, on souhaite souvent associer une bobine d'inductance à un circuit électronique, par exemple à un circuit intégré, monté sur une plaque de circuit imprimé. Une telle configuration est décrite par exemple dans WO-91/19302. La bobine est généralement réalisée par bobinage d'un fil autour d'un noyau. De telles bobines sont complexes à réaliser, donc relativement coûteuses. En outre, la connexion entre le circuit imprimé et la bobine occasionne certaines difficultés de montage supplémentaires et pose des problèmes de fiabilité, notamment lorsque ces éléments sont intégrés dans une carte à puce n'offrant pas de protection efficace face aux déformations et aux contraintes mécaniques. D'autre part, l'épaisseur de la bobine pose aussi souvent un problème lorsqu'elle doit être intégrée dans un dispositif miniaturisé ou dans une carte à puce dont on souhaite conserver l'épaisseur normalisée de 0,76 mm.

Pour pallier à ces difficultés, on connaît aussi des dispositifs dans lesquels les spires de l'inductance sont constituées directement par les pistes conductrices du circuit imprimé. Les pistes du circuit imprimées sont généralement réalisées par voie photochimique, ce qui nécessite de nombreuses opérations coûteuses et utilise des produits polluants.

US-4 555 291 décrit un procédé de fabrication de circuit imprimé essentiellement mécanique. Un film métallique fin est préalablement découpé en forme de spirale. Les différentes spires ne sont pas totalement séparées afin de rigidifier la spirale découpée. La spirale est ensuite fixée sur une feuille de matériau diélectrique, et un deuxième dispositif de coupe est mis en oeuvre pour supprimer les interconnexions entre spires, laissant subsister un circuit de nature inductive.

Cette solution est complexe à appliquer et nécessite notamment deux opérations de découpe distinctes. L'épaisseur du film métallique prédécoupé doit être suffisante pour que celui-ci puisse être transporté sans se déformer ou se déchirer; de même, la largeur des spires et des intervalles découpés entre les spires doit être suffisante pour assurer un minimum de rigidité au film avant stratification sur le support diélectrique.

On connaît d'autres procédés de fabrication de circuit imprimé à partir d'un film synthétique revêtu d'une couche conductrice superficielle, dans lesquels les différentes pistes conductrices sont démarquées par étampage mécanique de ladite couche conductrice effectué au moyen d'une matrice d'étampage. FR-2 674 724, GB-1138628, ou US-4 356 627 par exemple décrivent des variantes d'un tel procédé. Il est difficile d'obtenir des pistes de largeur très réduites avec ces techniques d'étampage. En outre, le film synthétique doit avoir une épaisseur suffisante pour supporter la pression d'étampage et rester suffisamment rigide même dans les régions repoussées par la matrice d'étampage.

D'autres procédés connus de fabrication de circuit imprimé à partir d'un film synthétique revêtu d'une couche conductrice superficielle comprennent une opération de démarcation des différentes pistes conductrices constituant le circuit imprimé par fraisage de la couche superficielle du circuit imprimé (cf. DE-3 330 738 et US-4 138 924). Les interstices entre pistes conductrices ont donc nécessairement une largeur assez importante correspondant au moins à la largeur de l'outil de fraisage. Il n'est donc pas possible d'obtenir une densité de pistes optimale. En outre, le fraisage produit des copeaux qui doivent être soigneusement retirés pour éviter des courts-circuits éventuels entre pistes. Lorsque la couche métallique superficielle est réalisée en un matériau onéreux, par exemple en argent, il y a gaspillage de matériau.

DE-2 758 204 décrit un procédé de fabrication de circuit, en particulier d'inductance sous forme de circuit imprimé, dans lequel les différentes pistes constituant les spires de la bobine sont démarquées par usinage thermomécanique d'un film synthétique revêtu d'une couche métallique superficielle. Une pointe métallique (3) chauffée traverse la couche de métal superficielle et fait simultanément fondre une partie de la couche synthétique sous le métal.

Ce procédé est plus spécialement adapté pour réaliser différentes sortes de dispositifs ou pour des bobines dont l'épaisseur n'est pas critique. L'épaisseur de la couche synthétique (1) doit être suffisamment épaisse pour être entaillée par la pointe (3) et simultanément chauffée sans être traversée complètement. La régulation de la température de la pointe pose des difficultés supplémentaires; en outre, la pointe métallique (3) doit se déplacer suffisamment lentement pour que le matériau synthétique ait le temps de fondre. Ce procédé est donc inadapté pour fabriquer des bobines devant être par exemple intégrées dans des cartes à puces, et dont l'épaisseur aussi bien que le coût et le temps de fabrication doivent être minimisés.

Un but de la présente invention est donc de proposer un procédé de fabrication de circuit imprimé amélioré, en particulier lorsqu'il est utilisé pour fabriquer des bobines d'inductance pour carte à puce dont les spires sont constituées par les pistes conductrices du circuit imprimé.

### Exposé de l'invention

Selon un aspect de l'invention, ce but est atteint au moyen d'un procédé de fabrication de module électronique tel que spécifié par la revendication 1.

Ce procédé permet d'éviter les inconvénients mentionnés des procédés de l'art antérieur.

De surcroît, ce procédé permet d'obtenir un circuit imprimé d'une planéité remarquable. Lorsque le circuit imprimé est intégré dans une carte à puce, il est ainsi plus facile d'obtenir des faces externes de la carte rigoureusement planes, ce qui facilite notablement l'impression de motifs éventuels.

L'invention concerne en outre des cartes à puce incorporant un module électronique fabriquée par ce procédé.

Des variantes de l'invention, en particulier telles que spécifiées par les revendications dépendantes, permettent en outre d'augmenter encore la densité des circuits obtenus et/ou l'inductance des bobines obtenues.

### Description sommaire des dessins.

D'autres aspects et avantages de l'invention ressortiront de la description et des figures annexées qui illustrent:
la figure 1, une vue en coupe d'un film diélectrique revêtu d'une couche conductrice superficielle convenant pour être utilisé avec la présente invention,
la figure 2, une vue en coupe d'un poinçon d'étampage et d'un film diélectrique revêtu d'une couche conductrice superficielle avant démarcation des pistes conductrices,
la figure 3, une vue en coupe d'un film diélectrique revêtu d'une couche conductrice superficielle après démarcation des pistes conductrices,
la figure 4, une vue en coupe d'un film diélectrique revêtu sur chaque face d'une couche conductrice superficielle après démarcation de pistes conductrices sur chaque face,
la figure 5, une vue en coupe d'un film diélectrique revêtu sur une face de plusieurs couches conductrices superficielles après démarcation des pistes conductrices,
la figure 6, une vue en coupe d'un film diélectrique revêtu sur une face de plusieurs couches conductrices superficielles après démarcation des pistes conductrices,
la figure 7, une vue latérale de différents outils de coupe utilisables dans le procédé de l'invention,
la figure 8, une vue en perspective d'une carte à puce comprenant un circuit imprimé à une seule face selon l'invention,
la figure 9, une vue en perspective d'une carte à puce comprenant un circuit imprimé selon l'invention assemblé entre deux feuilles de protection,
la figure 10, une vue en perspective d'un circuit imprimé avant pliage, réalisé selon une variante de l'invention comprenant une étape de pliage.

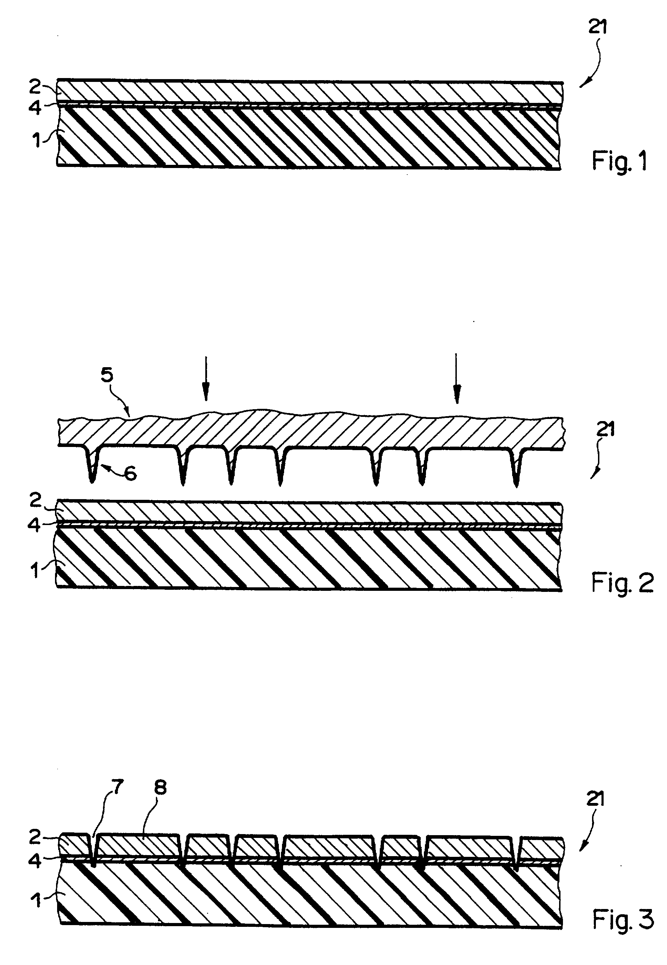

La figure 1 illustre une vue en coupe d'un film 1 revêtu d'une couche conductrice superficielle 2. Le film 1 est constitué de préférence d'un matériau diélectrique quelconque, par exemple d'un matériau synthétique type PVC ou de carton. Selon l'application, on choisira un film souple ou au contraire un substrat plus rigide. Le film 1 peut aussi être constitué d'un matériau composite ou multicouche, par exemple d'un stratifié comprenant plusieurs couches de matériau synthétique, de carton et/ou de métal.

La couche conductrice superficielle 2 est appliquée par un procédé connu sur le film 1 et maintenue par exemple par soudage ou au moyen de colle 4. La colle 4 peut par exemple être une colle à chaud ou une colle à froid; il est aussi possible d'utiliser en guise de colle 4 une feuille adhésive double face ou un film thermocollant. La couche 2 est réalisée en un métal approprié, par exemple en cuivre, en aluminium, en argent ou en alliage conducteur.

Dans une variante, la couche conductrice superficielle 2 est appliquée par collage sur une plaque métallique plutôt que sur un film diélectrique. L'isolation entre pistes conductrices (voir ci-dessous) est alors assurée uniquement par la couche de colle 4 qui remplit le rôle de film diélectrique. La couche de colle 4 doit dans ce cas être parfaitement isolante électriquement.

La figure 2 représente une vue en coupe d'un poinçon d'étampage 5 au-dessus du film diélectrique avant démarcation des pistes conductrices. Le poinçon d'étampage 5 présente des surfaces de contact coupantes 6 avec la couche superficielle 2 sur le film synthétique 1.

Le poinçon d'étampage 5 est abaissé grâce à des moyens non représentés, avec une pression juste suffisante pour que les surfaces de contact coupantes 6 perforent et découpent la couche métallique superficielle 2. Le profil des surfaces 6 est suffisamment aiguisé pour que le poinçon découpe des entailles 7 fines dans la couche 2, sans retirer de matière conductrice comme dans les procédés de fraisage ni repoussement vers la profondeur comme dans les procédés d'étampage du type GB-1138628. La matière métallique est ici incisée par les surfaces 6.

La figure 3 illustre une vue en coupe d'un film diélectrique 1 revêtu d'une couche métallique 2 après démarcation des pistes conductrices 8. On voit que les entailles 7 sont juste assez profondes pour traverser la couche métallique 2, la couche de colle éventuelle 4 et éventuellement effleurer la couche diélectrique synthétique 1. Dans une variante, les entailles 7 ne traversent complètement que la couche métallique superficielle, le fond des entailles étant au milieu de la couche de colle 4. De cette manière, le film synthétique 1 est aussi peu affaibli que nécessaire par l'usinage des démarcations entre pistes conductrices 8 et peut avoir une épaisseur minimale.

Pour optimiser la densité des pistes conductrices 8 sur le circuit imprimé, la largeur des entailles 7 est aussi fine que possible. Si le substrat 1 est particulièrement souple, la largeur sera toutefois suffisante pour éviter tout risque de court-circuitage des pistes conductrices 8.

Une disposition des pistes conductrices 8 adaptée, par exemple en spirale, permet de réaliser aisément des éléments inductifs dont les spires sont constituées par les pistes conductrices du circuit imprimé. Des opérations d'usinage supplémentaires traditionnelles, par exemple de perçage et de soudage, peuvent ensuite être effectuées pour fixer des composants discrets sur le circuit imprimé ainsi réalisé.

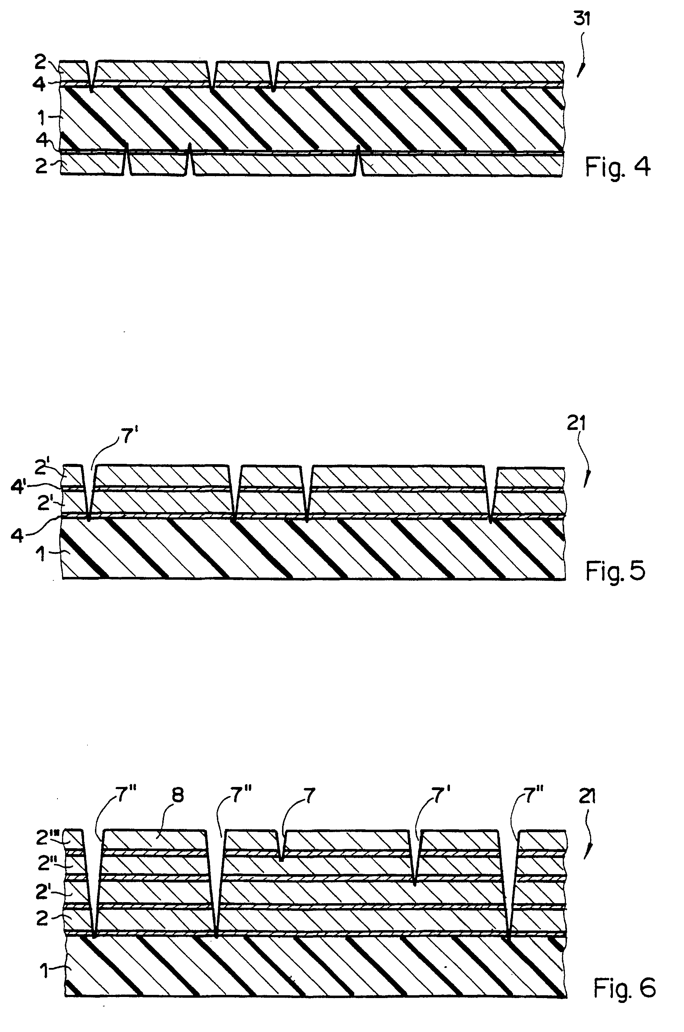

La figure 4 illustre une vue en coupe d'un film diélectrique 1 revêtu sur chaque face d'une couche conductrice superficielle 2 après démarcation de pistes conductrices 8 sur chaque face. Les entailles 7 délimitant les pistes 8 sur chaque face sont de préférence réalisées en une seule opération. Pour cela, le film diélectrique 1 revêtu sur chaque face d'une couche conductrice 2 est serré entre deux poinçons d'étampage non représentés qui présentent chacun des surfaces de contact coupantes 6 avec la surface métallique. Il est cependant également possible de réaliser les entailles 7 sur les deux faces en deux opérations, une face après l'autre.

Comme le procédé de l'invention peut être utilisé même avec des films diélectriques 1 d'épaisseur très fine, cette variante permet de réaliser très simplement des éléments capacitifs dont les armatures sont constituées par des pistes métalliques superposées sur chaque face. Ces composants peuvent par exemple être combinés avec des éléments inductifs pour constituer des circuits résonnants LC de volume réduit. Si le couplage capacitif entre les pistes sur les deux faces doit être réduit, on choisira au contraire des motifs de pistes conductrices sur les deux faces avec un minimum de recouvrements.

La figure 5 illustre une vue en coupe d'un film diélectrique revêtu sur une de ses faces de plusieurs couches conductrices superficielles après démarcation des pistes conductrices. Le film diélectrique 1 est revêtu dans cet exemple d'un premier film métallique 2 fixé par une première couche de colle 4. Un deuxième film métallique 2' est fixé sur le premier film 2 par une deuxième couche de colle 4'. La deuxième couche de colle 4' agit également comme isolant entre les deux couches métalliques 2 et 2'. Si nécessaire, il est aussi possible d'intercaler une couche d'isolant supplémentaire entre les deux couches métalliques, par exemple une couche synthétique supplémentaire. Il est en outre naturellement possible de superposer plus de deux couches métalliques 2, 2' l'une au-dessus de l'autre.

Dans cette variante, l'outil de coupe 5 utilisé pour démarquer les pistes conductrices 8 est conçu de manière à tailler des entailles 7' suffisamment profondes pour traverser en une seule opération toutes les couches métalliques 2, 2', etc.. Le motif constitué par les pistes conductrices 8 sur les différentes couches conductrices 2, 2' est donc identique. En connectant les différentes couches entre elles aux endroits appropriés, par exemple avec des trous métallisés, cette disposition permet de réaliser des circuits d'inductance élevée.

Il est naturellement aussi possible de fabriquer des circuits multicouches avec des motifs variables sur les différentes couches. La figure 6 illustre un exemple d'un film diélectrique 1 revêtu sur sa face supérieure de quatre couches conductrices superficielles 2, 2', 2", 2''' isolées et fixées mutuellement par un adhésif 4, 4', 4", 4"'. La profondeur des entailles 7 usinées en une seule opération par l'outil de coupe est ici variable; certaines entailles 7" traversent ainsi toutes les couches métallisées superposées tandis que d'autres (7) ne traversent que la couche supérieure 2''', d'autres encore (7') traversant plusieurs couches 2''', 2" mais pas toutes. De cette manière, on peut réaliser des topologies de pistes différentes sur les différentes couches.

Seuls des circuits particuliers, dans lesquels les pistes conductrices sur les couches métalliques inférieures 2 sont constituées par la juxtaposition d'une ou plusieurs pistes sur les couches supérieures, peuvent être obtenus par usinage d'entailles sur un film multicouches en une seule opération. Pour obtenir des circuits multicouches avec une topologie des pistes conductrices complètement libre sur chaque couche, il est nécessaire de prévoir plusieurs opérations successives:
laminage d'une ou plusieurs premières couches métallisées inférieures sur un film diélectrique
usinage d'entailles démarquant des pistes conductrices sur cette ou ces premières couches
laminage de couches métallisées supérieures
usinage d'entailles démarquant des pistes conductrices sur cette ou ces couches supérieures.

L'homme du métier comprendra qu'il est naturellement possible de combiner librement les variantes évoquées ci-dessus. Par exemple, il est possible de réaliser des circuits revêtus sur chaque face de plusieurs couches conductrices superficielles.

L'usinage d'entailles 7, 7', 7" comme décrit ci-dessus, au moyen d'un poinçon d'étampage présentant des surfaces de contact coupantes avec la couche conductrice superficielle, est très rapide, mais nécessite au préalable la fabrication d'un poinçon d'étampage avec le motif des démarcations entre pistes conductrices. Cette solution convient donc seulement à la fabrication de circuits imprimés en grande ou en moyenne série. De surcroît, pour assurer une découpe propre des couches métalliques, il est nécessaire de remplacer ou d'affûter de temps à autre les surfaces coupantes du poinçon d'étampage.

Dans une variante particulièrement adaptée à la fabrication de plus petites séries ou de prototypes, les entailles 7, 7', 7" peuvent être découpées au moyen d'une table de découpe conventionnelle connue par exemple dans le domaine de la découpe de films autocollants pour réalisations publicitaires ou autres. Dans ce cas, le motif des démarcations entre pistes conductrices est préalablement dessiné au moyen d'un logiciel adapté sur un ordinateur, puis mémorisé dans une mémoire électronique. Ce dessin est ensuite utilisé pour commander le déplacement séquentiel d'une lame 10 sur la table de découpe.

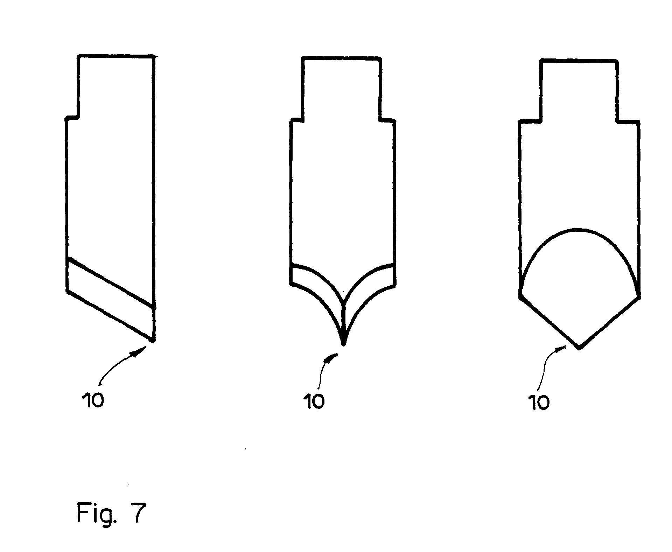

Certaines tables de découpe permettent un contrôle de la direction de la lame dans les arrondis et/ou des mouvements de va-et-vient de la lame. La forme de la lame 10 sera choisie en conséquence, par exemple parmi les variantes de la figure 7 et selon l'épaisseur de la couche métallique à découper. La lame est suffisamment tranchante pour découper la couche superficielle sans retrait de matière conductrice ni repoussement vers la profondeur. Sa largeur est minimale afin laisser subsister des pistes conductrices 8 de largeur maximale. La profondeur est juste suffisante pour traverser la couche métallique superficielle sans trop affaiblir la couche de diélectrique 1, qui pourra ainsi avoir une épaisseur minimale. Si des entailles de profondeur variées sont nécessaires, par exemple pour fabriquer des circuits multicouches avec des motifs variables sur les différentes couches (fig. 6), il est nécessaire de remplacer la lame à chaque changement de profondeur désiré. Il est aussi possible d'utiliser une table de découpe munie de plusieurs porte-lames équipés de lames de profondeur différentes, ou de prévoir des moyens pour contrôler la profondeur de pénétration de la lame.

Selon la largeur des entailles 7 et la flexibilité du substrat 1, des contacts électriques entre pistes conductrices voisines 8 risquent de se former lorsque les entailles se referment en cas de déformation du circuit imprimé. Si nécessaire, un matériau synthétique ou thermoplastique quelconque peut être inséré ou fondu dans les entailles 7 pour garantir une séparation électrique des pistes dans toutes conditions.

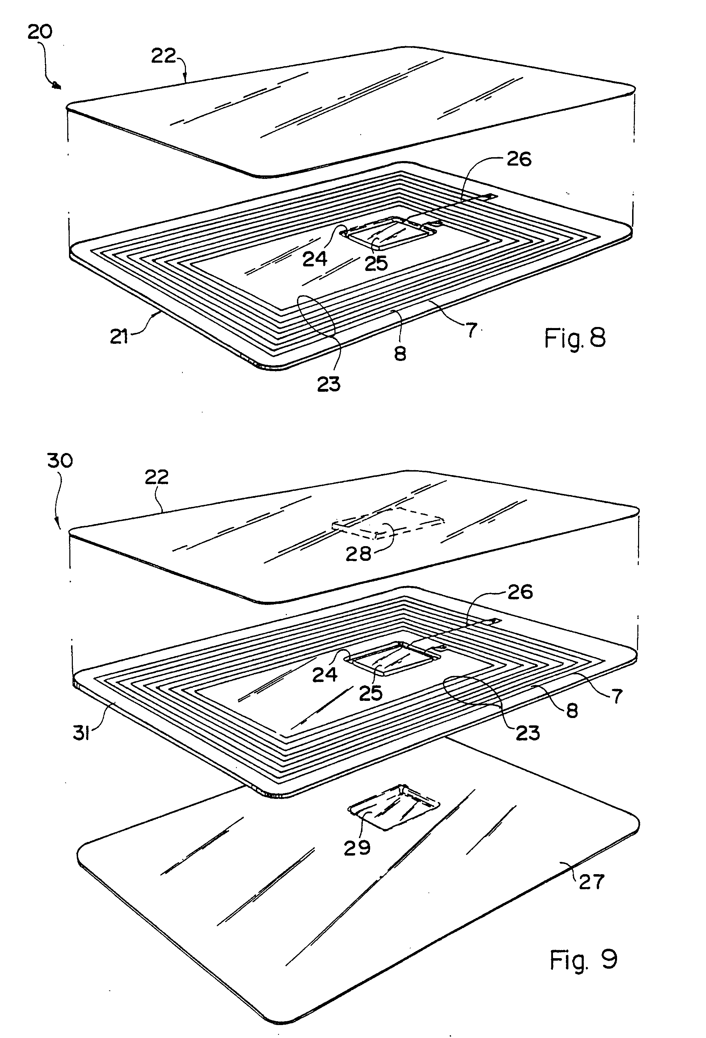

L'invention convient particulièrement à la fabrication de circuits imprimés dont l'épaisseur et éventuellement le poids doivent être minimisée. Par exemple, ce procédé est idéal pour des circuits imprimés destinés à des cartes à puce. La figure 8 illustre un exemple de carte à puce 20 selon l'invention.

La carte à puce est constituée d'un circuit imprimé 21 à une seule face selon l'invention, correspondant par exemple à l'une des variantes illustrées par les figures 3, 5 ou 6, et d'une feuille supérieure de protection et de décoration 22. La face inférieure de la feuille 21, qui ne comporte pas de pistes, peut également être imprimée. Le circuit imprimé 21 est formé d'un substrat 1 suffisamment rigide et d'une ou plusieurs couches superficielles conductrices 2, 2', etc.. Des entailles 7 sont usinées selon le procédé décrit ci-dessus dans la couche conductrice de manière à délimiter une piste conductrice en spirale 8 constituant un élément inductif 23. Le nombre de spires est choisi en fonction de l'inductance désirée. Comme le procédé d'usinage de l'invention produit des entailles 7 de largeur minimale entre les spires 8, il est possible de loger sur une surface donnée un maximum de spires et donc d'obtenir une inductance élevée. Pour augmenter encore l'inductance, on choisira de préférence un circuit à plusieurs couches conductrices 2, 2', etc. selon l'exemple de la figure 5 ou 6.

Un logement 24 est prévu dans une portion de la feuille inférieure 21 non occupée par les pistes conductrices 8, dans cet exemple à l'intérieur de l'élément inductif 23. Un circuit intégré 25 est fixé dans ce logement 24 et connecté aux deux extrémités de l'élément inductif 23. La connexion entre le circuit 25 et la portion interne de l'élément inductif 23 peut être faite directement. La connexion avec la portion externe de l'élément inductif 23 doit en revanche être faite par l'intermédiaire d'un pont 26 par-dessus les spires 8. Le pont 26 peut par exemple être constitué par un simple fil soudé par-dessus ou par-dessous les pistes conductrices 8. Dans le cas d'un circuit à plusieurs couches conductrices, il est aussi possible d'utiliser une des couches métallisées 2, 2', etc. pour effectuer le pont 26. Enfin, le pont peut être intégré dans le substrat 1 avant laminage des couches conductrices 2.

Suivant l'application désirée et la place résiduelle disponible sur la carte, d'autres composants que le circuit intégré 25 et l'élément inductif 23 peuvent être intégrés sur le circuit imprimé 21. Il est par exemple possible de placer sur le circuit un accumulateur (non représenté) qui pourra être rechargé depuis l'extérieur au moyen de l'élément inductif 23. Ces autres composants seront idéalement connectés mutuellement et avec les éléments 23 et 25 au moyen de pistes conductrices usinées de la manière décrite ci-dessus dans la ou les couches conductrices superficielles 2.

Après usinage des entailles 7 et connexion des divers composants entre eux, la feuille supérieure de protection 22 est posée sur la feuille inférieure 21 et assemblée par des moyens connus, par exemple par collage. On choisira par exemple une colle à chaud qui en fondant remplit les entailles 7 et prévient ainsi les risques mentionnés de courts-circuits entre pistes conductrices voisines.

L'homme du métier constatera ici que contrairement à la plupart des techniques connues de l'art antérieur, la fabrication des pistes conductrices 8 sur le circuit imprimé par le procédé de l'invention crée remarquablement peu d'inégalités de surface qui sont en outre compensées par la colle. Il est donc relativement aisé d'assembler la feuille supérieure 22 en obtenant une surface externe rigoureusement plane.

Le logement 24 pour le circuit intégré 25 dans la feuille inférieure 21 pourra si nécessaire être complété par un logement correspondant dans la feuille supérieure 22. Il est aussi possible de renoncer au logement 24 dans la feuille inférieure 21, et d'utiliser un logement correspondant plus profond dans la feuille supérieure 22. Dans une variante, la feuille supérieure 22 et/ou la feuille inférieure 21 sont munies d'une fenêtre au lieu d'un logement, laissant apparaître à l'extérieur de la carte le circuit 25, des pattes de connexion du circuit 25 ou des contacts liés au circuit 25.

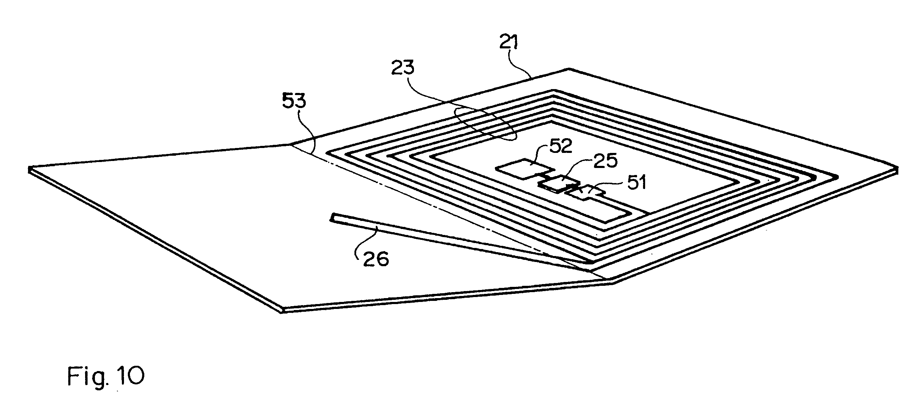

La figure 9 illustre un deuxième exemple de carte à puce 30 selon l'invention.

Dans cet exemple, la carte est constituée par un circuit imprimé 31, par exemple un circuit imprimé à double face selon l'exemple de la figure 4, assemblé entre une feuille de protection inférieure 27 et une feuille de protection supérieure 22. Les feuilles 22 et 27 sont assemblées au circuit imprimé 31 par n'importe quel moyen connu, par exemple par collage, puis éventuellement imprimées. Dans cette variante, le circuit imprimé 31 aura de préférence une épaisseur minimale, bien que comportant si nécessaire plusieurs couches conductrices sur chaque face. Des logements 28, respectivement 29 sont donc prévus dans la feuille inférieure 27 et dans la feuille supérieure 22 pour le circuit intégré 25. Naturellement, selon l'application, il est également possible d'utiliser un seul logement 28 ou 29 et/ou de remplacer au moins un des logements 28 ou 29 par une fenêtre permettant d'accéder au circuit 25 ou à des contacts liés au circuit 25 depuis l'extérieur de la carte.

Il va de soi que la variante de la figure 9 s'applique aussi à des circuits imprimés 21 simple face.

D'autres méthodes d'assemblage de cartes à puce peuvent être utilisées avec des circuits imprimés de l'invention, par exemple les procédés faisant l'objet de la demande de brevet WO-94/22111, dont le texte est ici incorporé par référence, ou l'un des procédés de l'art antérieur évoqué dans cette demande.

La figure 10 illustre un circuit imprimé dans une étape intermédiaire de fabrication, selon une variante de procédé destinée à faciliter la connexion entre le circuit 25 et la portion externe 26 de l'élément inductif 23. Cette variante est par exemple destinée à des étiquettes de sécurité pour protéger des marchandises, mais peut aussi être appliquée à des cartes à puce ou à d'autres dispositifs. Un circuit imprimé comprenant une portion en forme d'élément inductif 23 est usiné de la manière décrite ci-dessus sur un substrat 1 flexible, par exemple sur un support un carton. L'élément inductif 23 n'occupe qu'une moitié environ de la surface totale du substrat 1. Une des extrémités 26 de l'élément inductif 23 se prolonge sur l'autre moitié de la feuille 21. Cette extrémité peut par exemple être constituée par un fil discret soudé avec la portion externe de l'élément inductif 23. Dans une variante, cette extrémité 26 est usinée par incision dans la couche conductrice superficielle 2, de la manière décrite ci-dessus. Le reste de la couche superficielle 2 sur cette moitié de la feuille 21 peut alors être décollé en ne laissant subsister que l'extrémité 26.

Un élément électronique ou électrique 25 est assemblé dans une zone de la feuille 21 non occupée par les pistes conductrices, dans cet exemple à l'intérieur de l'élément inductif 23. L'élément 25 peut par exemple être un circuit intégré ou un fusible. Il est relié à la portion interne de l'élément inductif 23 par l'intermédiaire d'une plage de contact conductrice 51. En outre, l'élément 25 est relié à une deuxième plage de contact 52 destinée à établir la connexion avec l'extrémité 26 de l'élément inductif 23.

Après usinage des pistes conductrices constituant la bobine et assemblage de l'élément 25, la moitié de la feuille 21 occupée par les pistes conductrices est recouverte d'une couche isolante (non représentée). Pour cela, l'élément inductif 23 peut par exemple être recouvert d'une couche de laquage isolant ou d'une feuille adhésive isolante. La zone de contact 52 n'est toutefois pas recouverte pas la couche isolante.

La feuille 21 est ensuite repliée sur elle-même selon un axe de pliage 53, en sorte que les deux moitiés évoquées se superposent. L'extrémité 26 de l'élément inductif 23 est ainsi mise en contact électrique avec la plage de contact 52. Une connexion est ainsi constituée très simplement entre la portion externe de l'élément inductif 23 et l'élément 25. Les deux moitiés repliées de la feuille 21 peuvent être fixées mutuellement par exemple par collage.

Le procédé de l'invention convient aussi parfaitement pour la fabrication de circuits imprimés flexibles. De tels circuits sont utilisés par exemple pour fabriquer des connecteurs flexibles. En outre, le procédé est parfaitement adapté à chaque fois qu'une densité maximale des pistes à la surface du circuit imprimé doit être obtenue.

L'homme du métier réalisera en outre que ce procédé peut aussi être utilisé en combinaison avec n'importe quel autre procédé connu de fabrication de circuits imprimés. Il est par exemple possible de réaliser des cartes sur lesquels une partie des pistes conductrices est réalisée ou démarquée par voie électrochimique par exemple, le reste étant usiné de la manière spécifiée dans les revendications.

L'homme du métier réalisera que l'expression circuit imprimé est utilisée dans cette description et dans les revendications par convention, bien que l'invention s'applique surtout à des circuits et à des cartes réalisés sans étape d'impression au sens habituel.

## Revendications

1. Procédé de fabrication de module électronique (20) comprenant les étapes suivantes :
démarcation des différentes pistes conductrices (8) d'un circuit imprimé (21; 31) dans un film diélectrique (1) revêtu d'une couche conductrice superficielle (2) par usinage mécanique de ladite couche conductrice superficielle au moyen d'un outil de coupe tranchant (5, 10) permettant de couper des entailles (7, 7', 7") séparant lesdites pistes conductrices sans retrait de matière conductrice ni repoussement en profondeur en exerçant une pression latérale sur au moins un côté desdites pistes conductrices,
connexion d'au moins un composant électronique (25) sur ledites pistes conductrices (8),
assemblage d'au moins une feuille de protection (22; 27) sur ledit circuit imprimé (21; 31).

2. Procédé selon la revendication précédente, **caractérisé en ce que** ledit film diélectrique (1) est revêtu de plusieurs couches conductrices superposées (2, 2', 2", 2"') isolées mutuellement, et **en ce que** lesdites entailles (7, 7', 7") séparant les pistes conductrices (8) sont usinées de manière à traverser plusieurs couches conductrices superposées.

3. Procédé selon l'une des revendications précédentes, **caractérisé en ce que** chaque face dudit film diélectrique (1) est revêtue d'une ou plusieurs couches conductrices superficielles superposées (2, 2', 2", 2'''), différentes pistes conductrices (8) étant démarquées sur chaque face par usinage d'entailles (7, 7', 7") dans lesdites couches conductrices.

4. Procédé selon l'une des revendications précédentes, **caractérisé en ce que** ledit outil de coupe est un poinçon d'étampage (5) présentant des surfaces de contact coupantes (6) avec la couche conductrice superficielle (2; 2''').

5. Procédé selon l'une des revendications précédentes, **caractérisé en ce que** ledit outil de coupe est un couteau ou une lame (10) découpant séquentiellement des entailles (7, 7', 7") séparant les pistes conductrices (8) selon un motif préalablement enregistré dans une mémoire électronique.

6. Procédé selon l'une des revendications précédentes, **caractérisé en ce qu'**il comprend en outre une étape d'usinage dans ledit film d'au moins un logement (24) destiné à loger ledit au moins un composant électronique (25) connecté auxdites pistes conductrices (8).

7. Procédé selon l'une des revendications précédentes, **caractérisé en ce qu'**il comprend en outre une étape de recouvrement d'une partie des pistes conductrices (8) par une couche isolante, et une étape de repliage dudit film électrique selon un axe de pliage (53), de manière à créer au moins un pont électrique (26) entre des portions (26, 52) des pistes électriques (8) non recouvertes par ladite couche isolante.

8. Procédé selon l'une des revendications précédentes, **caractérisé en ce que** ladite au moins une feuille de protection (22 ; 27) est assemblée par collage sur ledit circuit imprimé (21 ; 31).

9. Procédé selon l'une des revendications précédentes, **caractérisé en ce qu'**il comporte une étape d'insertion de matériau dans lesdites entailles (7) pour garantir une séparation électrique des différentes pistes conductrices (8).

10. Procédé selon l'une des revendications 8 ou 9, **caractérisé en ce que** ladite au moins une feuille de protection (22 ; 27) est assemblée par collage à chaud sur ledit circuit imprimé (21 ; 31).

11. Procédé selon l'une des revendications précédentes, **caractérisé par** une étape de préparation dans ladite au mois une feuille de protection d'une fenêtre permettant d'accéder au composant électronique ou à des contacts liés audit composant électronique depuis l'extérieur de la carte.

12. Carte à puce (20; 30) comprenant un module électronique fabriqué selon le procédé d'une des revendications précédentes.

13. Carte à puce (20) selon la revendication précédente, **caractérisée en ce que** ledit circuit imprimé (21) est un circuit comportant des pistes conductrices sur une première face uniquement, ladite face étant recouverte par une feuille de protection (22), la face du circuit imprimé (21) opposée à ladite face étant une face externe de ladite carte à puce.

14. Carte à puce (30) selon la revendication précédente, **caractérisée en ce que** ledit circuit imprimé (31) est un circuit comportant des pistes conductrices sur les deux faces et **en ce qu'**il est assemblé entre une feuille de protection inférieure (27) et une feuille de protection supérieure (22).

## Claims

1. Method of producing an electronic module (20) comprising the , following steps :
demarcation of different conducting paths of a printed circuit (21; 31) in a dielectric film (1) covered by a superficial conductive layer (2) by mechanical machining of said superficial conductive layer by means of a sharp edged cutting tool (5, 10) allowing incisions (7, 7', 7") to be cut separating said conducting paths, without removal of conducting material or depth wise indentation by exerting a lateral pressure on at least one side of the conducting path,
connection of at least one electronic component (25) to said conducting paths (8);
assembly of at least one sheet of protection (22; 27) on said printed circuit (21; 31).

2. Method according to the preceding claim, **characterised in that** said dielectric film (1) is covered by a plurality of mutually insulated, superimposed conducting layers (2, 2', 2", 2'''), and **in that** said incisions (7, 7', 7") separating the conducting paths (8) are machined so as to pass through a plurality of superimposed conducting layers.

3. Method according to one of the preceding claims, **characterised in that** each face of said dielectric film (1) is covered by one or more superimposed superficial conducting layers (2, 2', 2", 2"'), different conducting paths (8) being demarcated on each face by machining of incisions (7, 7', 7") in said conducting layers.

4. Method according to one of the preceding claims, **characterised in that** said cutting tool is a stamping die (5) having sharp edged surfaces of contact (6) with the superficial conducting layer (2; 2''').

5. Method according to one of the preceding claims, **characterised in that** said cutting tool is a knife or a blade (10) cutting sequentially incisions (7, 7', 7") separating the conducting paths (8) according to a pattern recorded beforehand in an electronic memory.

6. Method according to one of the preceding claims, **characterised in that** it further comprises a step of machining in said film at least one accommodation (24) intended to accommodate an electronic component (25) connected to said conducting paths (8).

7. Method according to one of the preceding claims, **characterised in that** it further comprises a step of covering part of the conducting paths (8) by an insulating layer and a step of folding said dielectric film along a folding axis (53) in such a way as to create at least one electrical bridge (26) between portions (26, 52) of the electric paths (8) not covered by said insulating layer.

8. Method according to one of the preceding claims, **characterised in that** said at least one sheet of protection (22 ; 27) is assembled by gluing onto said printed circuit (21; 31).

9. Method according to one of the preceding claims, **characterised in that** it comprises a step of inserting a material in said incisions (7) to guarantee an electrical separation to the various conducting paths (8).

10. Method according to claim 8 or 9, **characterised in that** said at least one protective sheet (22; 27) is assembled by hot gluing onto said printed circuit (21; 31).

11. Method according to one of the preceding claims, **characterised by** a step of preparing, in said at least one protective sheet, a window allowing access to said at least one electronic component or to contacts linked to said electronic component from the outside of the card.

12. Chip card (20; 30) including an electronic module produced according to the method of one of the preceding claims.

13. Chip card (20) according to the preceding claim, **characterised in that** said printed circuit (21) is a circuit having conducting paths solely on a first face said face being covered by a protective sheet (22), the face of the printed circuit (21) opposite said face being an external face of said chip card.

14. Chip card (30) according to the preceding claim, **characterised in that** said printed circuit (31) is a circuit having conducting paths on both faces, and **in that** it is mounted between a lower protective sheet (27) and an upper protective sheet (22).

## Patentansprüche

1. Herstellungsverfahren für ein elektronisches Bauteil (20), die folgenden Schritte umfassend:
Abgrenzung der verschiedenen Leiterbahnen (8) einer gedruckten Schaltung (21; 31) in einer mit einer oberflächlichen Leiterschicht (2) überzogenen nichtleitenden Folie (1) durch mechanische Bearbeitung der benannten oberflächlichen Leiterschicht mit Hilfe eines scharfen Schneidwerkzeugs (5, 10), das es gestattet, Einschnitte (7, 7', 7"), die die benannten Leiterbahnen trennen, ohne Schwund oder Niederdrücken des Leitermaterials dadurch zu schneiden, indem ein seitlicher Druck auf zumindest eine Seite der benannten Leiterbahnen ausgeübt wird,
Anschluss von zumindest einem elektronischen Bauteil (25) auf den benannten Leiterbahnen (8),
Anfügen von zumindest einer Schutzfolie (22; 27) auf die benannte gedruckte Schaltung (21; 31).

2. Verfahren gemäss dem vorangehenden Anspruch, **dadurch gekennzeichnet, dass** die benannte nichtleitende Folie (1) von mehreren gegenseitig isolierten, übereinanderliegenden oberflächlichen Leiterschichten (2, 2', 2", 2"') überzogen ist und dass die benannten Einschnitte (7, 7', 7"), die die Leiterbahnen (8) trennen, so angebracht werden, dass sie mehrere übereinanderliegende Leiterschichten durchdringen.

3. Verfahren gemäss einem der vorangehenden Ansprüche, **dadurch gekennzeichnet, dass** jede Seite der benannten nichtleitenden Folie (1) von einer oder mehreren übereinanderliegenden oberflächlichen Leiterschichten (2, 2', 2", 2"') überzogen ist, wobei verschiedene Leiterbahnen (8) auf jeder Seite durch Anbringen von Einschnitten (7, 7', 7") in diesen Leiterschichten abgegrenzt werden.

4. Verfahren gemäss einem der vorangehenden Ansprüche, **dadurch gekennzeichnet, dass** das benannte Schneidwerkzeug ein Prägestempel (5) ist, der schneidende Berührungsflächen (6) für die oberflächliche Leiterschicht (2; 2"') aufweist.

5. Verfahren gemäss einem der vorangehenden Ansprüche, **dadurch gekennzeichnet, dass** das benannte Schneidwerkzeug ein Messer oder eine Klinge (10) ist, das gemäss einem im voraus in einem elektronischen Speicher aufgezeichneten Muster nacheinander die die Leiterbahnen (8) trennenden Einschnitte (7, 7', 7") schneidet.

6. Verfahren gemäss einem der vorangehenden Ansprüche, **dadurch gekennzeichnet, dass** es ausserdem einen Schritt umfasst, in die benannte Folie ein Lager (24) einzuarbeiten, das dazu bestimmt ist, ein an die benannten Leiterbahnen (8) angeschlossenes elektronisches Bauteil (25) unterzubringen.

7. Verfahren gemäss einem der vorangehenden Ansprüche, **dadurch gekennzeichnet, dass** es ausserdem einen Schritt umfasst, einen Teil der Leiterbahnen (8) durch eine isolierende Schicht abzudecken, sowie einen Schritt, die benannte elektrische Folie um eine Faltachse (53) so zusammenzufalten, dass zumindest eine elektrische Brücke (26) zwischen den Abschnitten (26, 52) der nicht durch die benannte isolierende Schicht abgedeckten elektrischen Bahnen (8) geschaffen wird.

8. Verfahren gemäss einem der vorangehenden Ansprüche, **dadurch gekennzeichnet, dass** die benannte, zumindest eine Schutzfolie (22; 27) durch Kleben auf die benannte gedruckte Schaltung (21; 31) aufgebracht wird.

9. Verfahren gemäss einem der vorangehenden Ansprüche, **dadurch gekennzeichnet, dass** es einen Schritt der Einfügung von Material in die benannten Einschnitte (7) umfasst, um eine elektrische Trennung der verschiedenen Leiterbahnen (8) zu gewährleisten.

10. Verfahren nach einem der Ansprüche 8 oder 9, **dadurch gekennzeichnet, dass** die benannte, zumindest eine Schutzfolie (22; 27) durch Heisskleben auf die benannte gedruckte Schaltung (21; 31) aufgebracht wird.

11. Verfahren gemäss einem der vorangehenden Ansprüche, **gekennzeichnet durch** einen Schritt, in der benannten, zumindest einen Schutzfolie ein Fenster herzurichten, das Zugriff auf das elektronische Bauteil oder auf die mit dem benannten elektronischen Bauteil verbundenen Kontakte von ausserhalb der Karte gestattet.

12. Chipkarte (20; 30) mit einer elektronischen Baugruppe, die nach dem Verfahren eines der vorangehenden Ansprüche hergestellt wurde.

13. Chipkarte (20) gemäss dem vorangehenden Anspruch, **dadurch gekennzeichnet, dass** die benannte gedruckte Schaltung (21) eine Schaltung ist, die Leiterbahnen nur auf einer ersten Seite umfasst, wobei die benannte Seite von einer Schutzfolie (22) überdeckt ist und die der benannten Seite gegenüberliegende Seite der gedruckten Schaltung (21) eine Aussenseite der benannten Chipkarte ist.

14. Chipkarte (30) gemäss dem vorangehenden Anspruch, **dadurch gekennzeichnet, dass** die benannte gedruckte Schaltung (31) eine Schaltung ist, die Leiterbahnen auf beiden Seiten umfasst, und dass sie zwischen einer unteren Schutzfolie (27) und einer oberen Schutzfolie (22) montiert ist.
